# EUROPEAN PATENT APPLICATION

(11) **EP 4 779 690 A1**
(43) Date of publication of application: **22.07.2026**
(21) Application number: 24869911.8
(22) Date of filing: 27.06.2024
(51) Int. Cl.: H01L 23/528

(54) **SEMICONDUCTOR DEVICE, CHIP, ELECTRONIC DEVICE AND SEMICONDUCTOR DEVICE MANUFACTURING METHOD**

(30) Priority: 28.09.2023 CN 202311290163
(71) Applicant: HUAWEI TECHNOLOGIES CO., LTD., Shenzhen 518129 (CN)
(72) Inventor: WANG, Tianyu, Shenzhen, Guangdong 518129 (CN); WANG, Cheng, Shenzhen, Guangdong 518129 (CN); ZHU, Jifeng, Shenzhen, Guangdong 518129 (CN)
(74) Representative: Maiwald GmbH
(86) International application number: PCT/CN2024/102022
(87) International publication number: WO 2025/066352

(57) **Abstract**

Embodiments of this application provide a semiconductor device, a chip, an electronic device, and a preparation method for the semiconductor device, and relate to the field of semiconductor bonding technologies, to improve electrical connection effect between two semiconductor devices. The semiconductor device includes a semiconductor structure and an interconnection layer. The interconnection layer is located on a side of the semiconductor structure, the interconnection layer includes a plurality of bonding portions that are spaced apart, the bonding portion includes a bonding pad and a metal glass layer, the bonding pad is connected to the semiconductor structure, and the metal glass layer covers a side that is of the bonding pad and that is away from the semiconductor structure. The semiconductor device is used in the chip.

## Description

This application claims priority to Chinese Patent Application No. 202311290163.3, filed with the China National Intellectual Property Administration on September 28, 2023 and entitled "SEMICONDUCTOR DEVICE, CHIP, ELECTRONIC DEVICE, AND PREPARATION METHOD FOR SEMICONDUCTOR DEVICE", which is incorporated herein by reference in its entirety.

### TECHNICAL FIELD

This application relates to the field of semiconductor bonding technologies, and in particular, to a semiconductor device, a chip, an electronic device, and a preparation method for the semiconductor device.

### BACKGROUND

With development of semiconductor technologies, a size of a semiconductor device becomes smaller, and a size of a pad disposed in the semiconductor device becomes smaller. In a related technology, a hybrid bonding technology may be used to connect pads of two semiconductor devices, so that the two semiconductor devices are electrically connected. However, in the related technology, bonding effect between the pads is poor, and consequently, electrical connection effect of the two semiconductor devices is poor.

### SUMMARY

Embodiments of this application provide a semiconductor device, a chip, an electronic device, and a preparation method for the semiconductor device, aiming at improvement of electrical connection effect between two semiconductor devices.

To achieve the foregoing objective, embodiments of this application provide the following technical solutions.

In one aspect, a semiconductor device is provided. The semiconductor device includes a semiconductor structure and an interconnection layer. The interconnection layer is located on a side of the semiconductor structure, the interconnection layer includes a plurality of bonding portions that are spaced apart, the bonding portion includes a bonding pad and a metal glass layer, the bonding pad is connected to the semiconductor structure, and the metal glass layer covers a side that is of the bonding pad and that is away from the semiconductor structure.

In the semiconductor device, the metal glass layer may be electrically connected to the bonding pad, and the metal glass layer may be electrically connected to the semiconductor structure via the bonding pad. The metal glass layer of the semiconductor device may be bonded to a metal glass layer of another semiconductor device through hybrid bonding, the metal glass layers of the two semiconductor devices may form bonding connection portions, and the bonding connection portion may be electrically connected to a semiconductor structure via a bonding pad. In this case, the semiconductor structures of the two semiconductor devices may be electrically connected via the bonding pads and the bonding connection portions. In a bonding process of the metal glass layers of bonding portions of the two semiconductor devices, the metal glass layers of the bonding portions of the two semiconductor devices are aligned with high precision, and then hybrid bonding and annealing are performed. In the annealing process, when a temperature reaches a supercooled liquid phase region, the metal glass layers of the two semiconductor devices may be softened to form a liquid-like state. This can generate effect similar to liquid flowing, reduce a gap between contact interfaces of the metal glass layers of the two semiconductor devices, improve contact effect of the metal glass layers of the two semiconductor devices, improve bonding effect of the two semiconductor devices, improve electrical connection quality of the two semiconductor devices, and improve a subsequent electrical test and reliability test of a chip. In addition, before the metal glass layers of the two semiconductor devices are bonded, an oxide layer may exist on a surface of the metal glass layer. The metal glass layer is of an amorphous structure (that is, a non-crystal structure) in microscope. At the metal glass layer, because metal atoms are not at positions with lowest energy, the metal atoms are in a high energy state in terms of structure. In this case, the metal glass layer may excite motion of local metal atomic clusters of the metal glass layer through ultrasonic vibration at a normal temperature, and the motion of the atomic clusters may enable the atomic clusters to break through an oxide layer on a bonding interface of the metal glass layer, so that the metal glass layers of the two semiconductor devices may break through oxide layers on the surfaces for bonding. Therefore, bonding effect of the metal glass layers of the two semiconductor devices is good. In addition, because the motion of the atomic clusters at the metal glass layer can break through the oxide layer on the surface at the normal temperature, the metal glass layers of the two semiconductor devices can be bonded at the normal temperature. In addition, after hybrid bonding is performed on the metal glass layers of the two semiconductor devices, in the annealing process, the motion of the metal atomic clusters is more intense. This helps the metal atomic clusters break through the oxide layer on the bonding interface of the metal glass layer, to improve bonding effect of the metal glass layers of the two semiconductor devices.

In some embodiments, the interconnection layer further includes a dielectric layer, the bonding portion is embedded in the dielectric layer, the dielectric layer exposes a first surface of the metal glass layer, and the first surface is a surface that is of the metal glass layer and that is away from the semiconductor structure. The dielectric layer includes a second surface that is away from the semiconductor structure. The first surface is closer to the semiconductor structure than the second surface.

The first surface of the metal glass layer and the dielectric layer may enclose expansion space. In the bonding process of the metal glass layers of the bonding portions of the two semiconductor devices, the metal glass layers of the two semiconductor devices may expand, and sizes of the metal glass layers may increase. The first surface of the metal glass layer and the dielectric layer enclose the expansion space, so that the metal glass layer may expand into the expansion space. This avoids a gap between the bonded metal glass layers of the two semiconductor devices due to excessive protrusion of the expanded metal glass layer from the second surface of the dielectric layer. In embodiments of this application, the first surface is closer to the semiconductor structure than the second surface, to avoid a gap between the two bonded semiconductor devices due to expansion of the metal glass layers.

In some embodiments, a distance between the first surface and the second surface in a first direction is greater than or equal to 20 Å and less than or equal to 300 Å, and the first direction is perpendicular to the first surface.

The distance between the first surface and the second surface in the first direction is greater than or equal to 20 Å, so that the metal glass layer has sufficient expansion space. This avoids a gap between the bonded metal glass layers of the two semiconductor devices due to excessive protrusion of the expanded metal glass layer from the second surface caused by insufficient expansion space, so that bonding effect of the metal glass layers of the two semiconductor devices is not affected. Therefore, the distance between the first surface and the second surface in the first direction is greater than or equal to 20 Å, to avoid a gap between the two semiconductor devices after the metal glass layers are bonded.

The distance between the first surface and the second surface in the first direction is less than or equal to 300 Å, to avoid a case in which the expansion space cannot be filled with the expanded metal glass layer due to the expansion space of the metal glass layer being excessively large. If the expansion space is excessively large, a gap exists between the metal glass layers of the two semiconductor devices after expansion, and contact effect of the metal glass layers of the two semiconductor devices is affected. Therefore, the distance between the first surface and the second surface in the first direction is less than or equal to 300 Å, to reduce impact of excessively large expansion space on bonding effect of the metal glass layers of the two semiconductor devices.

In some embodiments, the dielectric layer includes a first isolation layer, an intermediate layer, and a second isolation layer that are sequentially stacked on the semiconductor structure, the bonding pad is embedded in the first isolation layer, the intermediate layer, and the second isolation layer, and the metal glass layer is embedded in the second isolation layer.

The second surface of the dielectric layer is a surface that is of the second isolation layer and that is away from the semiconductor structure. In this way, the first surface of the metal glass layer may be lower than or flush with the second surface of the dielectric layer.

In some embodiments, a ratio of thickness of the bonding pad to thickness of the metal glass layer is greater than or equal to 10.55 and less than or equal to 158.9.

The ratio of the thickness of the bonding pad to the thickness of the metal glass layer is greater than or equal to 10.55, to prevent the thickness of the metal glass layer from being excessively large. If the thickness of the metal glass layer is excessively large, the expanded metal glass layer may excessively protrude from the second surface. In this case, there may be a gap between the two semiconductor devices after the metal glass layers of the two semiconductor devices are bonded. Therefore, the ratio of the thickness of the bonding pad to the thickness of the metal glass layer is greater than or equal to 10.55, to avoid a gap between the two semiconductor devices due to the thickness of the metal glass layer being excessively large. In addition, the ratio of the thickness of the bonding pad to the thickness of the metal glass layer is less than or equal to 158.9, to prevent the thickness of the metal glass layer from being excessively small. If the thickness of the metal glass layer is excessively small, there may be a gap between the metal glass layers of the two semiconductor devices after the metal glass layers of the two semiconductor devices expand, and consequently, the metal glass layers of the two semiconductor devices are not fully combined. Therefore, the ratio of the thickness of the bonding pad to the thickness of the metal glass layer is less than or equal to 158.9, to avoid a case in which the metal glass layers of the two semiconductor devices are not fully combined due to the thickness of the metal glass layer being excessively small.

In some embodiments, the bonding pad includes a first part and a second part, one end of the first part is connected to the semiconductor structure, the second part is connected to the other end of the first part, a cross-sectional area of the first part on a first reference plane is less than a cross-sectional area of the second part on a second reference plane, and the first reference plane and the second reference plane are both parallel to the surface that is of the metal glass layer and that is away from the semiconductor structure. A ratio of thickness of the first part to the thickness of the metal glass layer is greater than or equal to 5.55 and less than or equal to 75. A ratio of thickness of the second part to the thickness of the metal glass layer is greater than or equal to 5 and less than or equal to 83.9.

The ratio of the thickness of the first part to the thickness of the metal glass layer is greater than or equal to 5.55, to prevent the thickness of the metal glass layer from being excessively large. If the thickness of the metal glass layer is excessively large, the expanded metal glass layer may excessively protrude from the second surface. In this case, there is a gap between the two semiconductor devices after the metal glass layers of the two semiconductor devices are bonded. Therefore, the ratio of the thickness of the first part to the thickness of the metal glass layer is greater than or equal to 5.55, to avoid a gap between the two semiconductor devices due to the thickness of the metal glass layer being excessively large. In addition, the ratio of the thickness of the second part to the thickness of the metal glass layer is less than or equal to 75, to prevent the thickness of the metal glass layer from being excessively small. If the thickness of the metal glass layer is excessively small, there may be a gap between the metal glass layers of the two semiconductor devices after the metal glass layers of the two semiconductor devices expand, and consequently, the metal glass layers of the two semiconductor devices are not fully combined. Therefore, the ratio of the thickness of the second part to the thickness of the metal glass layer is less than or equal to 75, to avoid a case in which the metal glass layers of the two semiconductor devices are not fully combined due to the thickness of the metal glass layer being excessively small.

In some embodiments, the thickness of the metal glass layer is greater than or equal to 200 Å and less than or equal to 900 Å.

The thickness of the metal glass layer is greater than or equal to 200 Å, to prevent the thickness of the metal glass layer from being excessively small. If the thickness of the metal glass layer is excessively small, there may be a gap between the metal glass layers of the two semiconductor devices after the metal glass layers of the two semiconductor devices expand, and consequently, the metal glass layers of the two semiconductor devices are not fully combined. Therefore, the thickness of the metal glass layer is greater than or equal to 200 Å, to avoid a case in which the metal glass layers of the two semiconductor devices are not fully combined due to the thickness of the metal glass layer being excessively small. In addition, the thickness of the metal glass layer is less than or equal to 900 Å, to prevent the thickness of the metal glass layer from being excessively large. If the thickness of the metal glass layer is excessively large, the expanded metal glass layer may excessively protrude from the second surface. In this case, there is a gap between the two semiconductor devices after the metal glass layers of the two semiconductor devices are bonded. Therefore, the thickness of the metal glass layer is less than or equal to 900 Å, to avoid a gap between the two semiconductor devices due to the thickness of the metal glass layer being excessively large.

In some embodiments, the thickness of the bonding pad is greater than or equal to 9500 Å and less than or equal to 31780 Å.

The thickness of the bonding pad is greater than or equal to 9500 Å, to prevent the thickness of the metal glass layer on the surface of the bonding pad from being excessively large due to the thickness of the bonding pad being excessively small. If the thickness of the metal glass layer is excessively large, the expanded metal glass layer may excessively protrude from the second surface. In this case, there may be a gap between the two semiconductor devices after the metal glass layers of the two semiconductor devices are bonded. Therefore, the thickness of the bonding pad is greater than or equal to 9500 Å, to avoid a gap between the two semiconductor devices due to the thickness of the metal glass layer being excessively large. The thickness of the bonding pad is less than or equal to 31780 Å, to prevent the thickness of the metal glass layer on the surface of the bonding pad from being excessively small due to the thickness of the bonding pad being excessively large. If the thickness of the metal glass layer is excessively small, there may be a gap between the metal glass layers of the two semiconductor devices after the metal glass layers of the two semiconductor devices expand, and consequently, the metal glass layers of the two semiconductor devices are not fully combined. Therefore, the thickness of the bonding pad is less than or equal to 31780 Å, to avoid a case in which the metal glass layers of the two semiconductor devices are not fully combined due to the thickness of the metal glass layer being excessively small.

In some embodiments, a material of the metal glass layer includes CuZr.

After the metal glass layers of the two semiconductor devices are bonded, during annealing of the two semiconductor devices, when an annealing temperature reaches a crystallization temperature of CuZr, atomic positions of Cu atoms and Zr atoms in CuZr may rearrange. Specifically, the Cu atoms may be crystallized, and single-crystal Cu is precipitated. In this case, the bonding connection portions formed after the metal glass layers of the two semiconductor devices are bonded may include CuZr and single-crystal Cu. Resistivity of single-crystal Cu is less than resistivity of CuZr. Therefore, the material of the metal glass layer includes CuZr, to reduce resistivity of the bonding connection portion. In addition, single-crystal Cu may further destroy the oxide layer on the bonding surface of the metal glass layers 342 of the two semiconductor devices 300, to improve bonding effect of the metal glass layers 342 of the two semiconductor devices 300.

In another aspect, a chip is provided. The chip includes two semiconductor devices in any one of the foregoing embodiments. Metal glass layers of a plurality of bonding portions of the two semiconductor devices are bonded, to form a plurality of bonding connection portions.

Because the chip includes the two semiconductor devices provided in some of the foregoing embodiments, the chip has same beneficial effect as the semiconductor device provided in some of the foregoing embodiments. Details are not described herein again.

In some embodiments, in the semiconductor device, there is a recess on a surface that is of a bonding pad of the bonding portion and that is away from a semiconductor structure of the semiconductor device, and the recess is filled with a part of the bonding connection portion.

The surface that is of the bonding pad and that is away from the semiconductor structure is not a smooth surface, and has the recess. In a process of bonding the metal glass layers of the two semiconductor devices, a temperature of the metal glass layer increases. When the temperature reaches a supercooled liquid phase region, the metal glass layer is in a liquid-like state. Therefore, the metal glass layer may be fluid, and the recess on the surface that is of the bonding pad and that is away from the semiconductor structure may be filled with the metal glass layer, to increase connection effect between the metal glass layer (namely, the bonding connection portion) and the bonding pad.

In some embodiments, a material of the bonding connection portion includes CuZr and single-crystal Cu.

After the metal glass layers of the two semiconductor devices are bonded, during annealing of the two semiconductor devices, when an annealing temperature reaches a crystallization temperature of CuZr, Cu atoms in CuZr may be crystallized, and single-crystal Cu is precipitated. In other words, the bonding connection portions formed after the metal glass layers of the two semiconductor devices are bonded may include CuZr and single-crystal Cu. Resistivity of single-crystal Cu is less than resistivity of CuZr, to reduce resistivity of the bonding connection portion.

In still another aspect, an electronic device is provided. The electronic device includes a circuit board and the chip provided in some of the foregoing embodiments, and the chip is disposed on the circuit board.

The electronic device has a same structure and same beneficial technical effect as the chip provided in some of the foregoing embodiments. Details are not described herein again.

In yet another aspect, a preparation method for a semiconductor device is provided. The preparation method for the semiconductor device includes: forming a dielectric layer on a surface of a semiconductor structure; forming a plurality of contact holes at the dielectric layer; forming a bonding pad in the contact hole; and forming a metal glass layer in the contact hole, where the metal glass layer is stacked and in contact with the bonding pad.

Because the preparation method for the semiconductor device is used to prepare the semiconductor device provided in some of the foregoing embodiments, the method has same beneficial effect as the semiconductor device provided in some of the foregoing embodiments. Details are not described herein again.

In some embodiments, the forming the bonding pads in the plurality of contact holes includes: depositing a metal material, where the contact hole is filled with the metal material; and removing the metal material located at a top of the contact hole, to form a first recess, where the metal material retained in the contact hole is the bonding pad, and the top of the contact hole is an area at one end that is of the contact hole and that is away from the semiconductor structure. The forming the metal glass layer in the contact hole includes: forming the metal glass layer in the first recess.

After the metal material located at the top of the contact hole is removed, the first recess may be formed, to provide accommodation space for disposing the metal glass layer. In addition, after the metal material located at the top of the contact hole is removed, the bonding pad may be formed. In this case, a side that is of the bonding pad and that is away from the semiconductor structure may have a flat surface, to provide the flat surface for forming the metal glass layer. This helps improve thickness uniformity of the metal glass layer.

In some embodiments, the forming the metal glass layer in the first recess includes: depositing a metal glass material, where the first recess is filled with the metal glass material, and the metal glass material covers the dielectric layer; and removing the metal glass material covering the dielectric layer, and retaining the metal glass material in the first recess, to form the metal glass layer.

A first surface of the metal glass layer may be flush with a second surface of the dielectric layer.

In some embodiments, the forming the metal glass layer in the first recess includes: depositing a metal glass material, where the first recess is filled with the metal glass material, and the metal glass material covers the dielectric layer; and removing the metal glass material on the dielectric layer and the metal glass material located at a top of the first recess, where the metal glass material retained in the first recess is the metal glass layer, and the top of the first recess is an area at one end that is of the first recess and that is away from the semiconductor structure.

A first surface of the metal glass layer is closer to the semiconductor structure than a second surface of the dielectric layer. In this case, the first surface of the metal glass layer and the dielectric layer may enclose expansion space. In a bonding process of the metal glass layers of the bonding portions of the two semiconductor devices, the metal glass layers of the two semiconductor devices may expand, and sizes of the metal glass layers may increase. The first surface of the metal glass layer and the dielectric layer enclose the expansion space, so that the metal glass layer may expand into the expansion space. This avoids a gap between the two semiconductor devices after the metal glass layers of the two semiconductor devices are bonded due to excessive protrusion of the expanded metal glass layer from the second surface of the dielectric layer. Therefore, the first surface is closer to the semiconductor structure than the second surface, to avoid a gap between the two bonded semiconductor devices due to expansion of the metal glass layers.

### BRIEF DESCRIPTION OF DRAWINGS

To describe technical solutions in this application more clearly, the following briefly describes accompanying drawings used for describing some embodiments of this application. It is clear that the accompanying drawings in the following descriptions are merely accompanying drawings in some embodiments of this application. A person of ordinary skill in the art may further derive other drawings from these accompanying drawings. In addition, the accompanying drawings in the following descriptions may be considered as diagrams, and are not intended to limit an actual size of a product, an actual procedure of a method, an actual timing of a signal, and the like in embodiments of this application.
FIG. 1 is a diagram of a structure of an electronic device according to an embodiment of this application;
FIG. 2 is a diagram of a structure of a chip in a related technology;
FIG. 3 is a diagram of a structure of a chip according to an embodiment of this application;
FIG. 4 is a diagram of a structure of a semiconductor device according to an embodiment of this application;
FIG. 5 is a diagram of another structure of a semiconductor device according to an embodiment of this application;
FIG. 6 is a flowchart of a preparation method for a semiconductor device according to an embodiment of this application;
FIG. 7 to FIG. 14 are diagrams of steps of a preparation method for a semiconductor device according to an embodiment of this application;
FIG. 15 is another flowchart of a preparation method for a semiconductor device according to an embodiment of this application;
FIG. 16 is still another flowchart of a preparation method for a semiconductor device according to an embodiment of this application;
FIG. 17 is yet another flowchart of a preparation method for a semiconductor device according to an embodiment of this application;
FIG. 18 is another flowchart of a preparation method for a semiconductor device according to an embodiment of this application; and
FIG. 19 to FIG. 24 are diagrams of other steps of a preparation method for a semiconductor device according to an embodiment of this application.

### DESCRIPTION OF EMBODIMENTS

The following clearly and completely describes technical solutions in some embodiments of this disclosure with reference to accompanying drawings. Apparently, the described embodiments are merely some rather than all of embodiments of this disclosure. All other embodiments obtained by a person of ordinary skill in the art based on embodiments provided in this disclosure shall fall within the protection scope of this disclosure.

Unless otherwise required in the context, throughout this specification and claims, the term "include (comprise)" and other forms of the term, for example, a third person singular form "includes (comprises)" and a present participle form "including (comprising)", are interpreted as "open and inclusive", namely, "include but not limited to". In descriptions of the specification, the terms such as "one embodiment (one embodiment)", "some embodiments (some embodiments)", "an example embodiment (example embodiments)", "an example (example)", "a specific example (specific example)", or "some examples (some examples)" are intended to indicate that a specific feature, structure, material, or characteristic related to the embodiment or example is included in at least one embodiment or example of this disclosure. The foregoing schematic representations of the terms do not necessarily refer to a same embodiment or example. Further, the particular feature, structure, material, or characteristic may be included in any one or more embodiments or examples in any appropriate manner.

The following terms "first" and "second" are merely intended for a purpose of description, and shall not be understood as an indication or implication of relative importance or implicit indication of a quantity of indicated technical features. Therefore, a feature limited by "first" or "second" may explicitly or implicitly include one or more features. In descriptions of embodiments of this disclosure, unless otherwise specified, "a plurality of" means two or more.

As used herein, "about" or "approximately" includes the stated values and the average values within an acceptable deviation range of a particular value, where the acceptable deviation range is determined by a person of ordinary skill in the art by considering an error (namely, a limitation of a measurement system) related to measurement being discussed and measurement of a specific quantity.

As used herein, "parallel" and "perpendicular to" include described cases and similar cases. A range of a similar case is in an acceptable deviation range. The acceptable deviation range is determined by a person of ordinary skill in the art by considering an error (namely, a limitation of a measurement system) related to measurement being discussed and measurement of a specific quantity. For example, "parallel" includes "absolutely parallel" and "approximately parallel", and an acceptable deviation range of "approximately parallel" may be, for example, a deviation within 5°. "Perpendicular to" includes "absolutely perpendicular to" and "approximately perpendicular to", and an acceptable deviation range of "approximately perpendicular to" may also be, for example, a deviation within 5°.

It should be understood that, when a layer or an element is referred to as on another layer or substrate, the layer or element may be directly on the another layer or substrate, or an intermediate layer may exist between the layer or element and the another layer or substrate.

Example implementations are described herein with reference to sectional views as idealized example drawings. In the accompanying drawings, for clarity, thickness of layers and areas of regions are increased. Therefore, a change in a shape in the accompanying drawings due to, for example, manufacturing techniques and/or tolerances may be envisaged. Therefore, example implementations should not be construed as being limited to a shape of a region shown herein, but include shape deviations due to, for example, manufacturing. For example, an etching region shown as a rectangle typically has a bending characteristic. Therefore, the regions shown in the accompanying drawings are essentially examples, and shapes of the regions are not intended to show actual shapes of regions of a device, and are not intended to limit a scope of the example implementations.

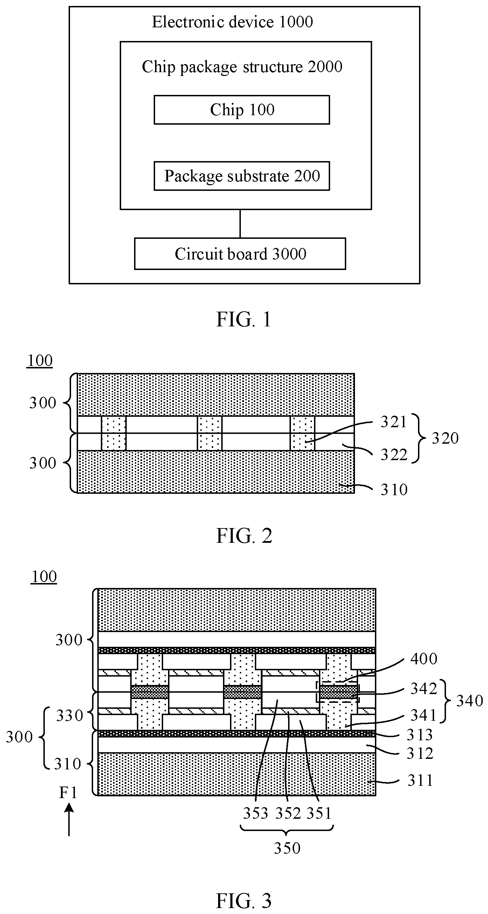

FIG. 1 is a diagram of a structure of an electronic device according to an embodiment of this application.

Refer to FIG. 1. An embodiment of this application provides an electronic device 1000. The electronic device 1000 may include any one of electronic products such as a complementary metal-oxide-semiconductor (complementary metal-oxide-semiconductor, CMOS) image sensor, a NAND memory, a high bandwidth memory, a mobile phone (mobile phone), a tablet computer (pad), a television, a smart wearable product (for example, a smartwatch or a smart band), a virtual reality (virtual reality, VR) terminal device, and an augmented reality (augmented reality, AR) terminal device. A specific form of the electronic device 1000 is not specially limited in embodiments of this application.

As shown in FIG. 1, the electronic device 1000 may include a chip package structure 2000 and a circuit board 3000, and the chip package structure 2000 is electrically connected to the circuit board 3000.

The chip package structure 2000 may include a chip 100 and a package substrate 200. The chip 100 may be packaged on the package substrate 200, and the chip 100 may be disposed on the circuit board 3000 via the package substrate 200. The chip 100 may be a three-dimensional integrated circuit (3-dimension integrated circuit, 3D IC).

FIG. 2 is a diagram of a structure of a chip 100 in a related technology.

Refer to FIG. 2. In some examples, the chip 100 may include two semiconductor devices 300. The semiconductor device 300 may include a semiconductor structure 310 and a connection layer 320, and the connection layer 320 is disposed on a side of the semiconductor structure 310. The connection layer 320 may include a plurality of pads 321 and an intermediate layer 322. The plurality of pads 321 may be embedded in the intermediate layer 322, and the plurality of pads 321 may be further electrically connected to the semiconductor structure 310.

A plurality of pads 321 of one semiconductor device 300 may be fastened to and electrically connected to a plurality of pads 321 of another semiconductor device 300, so that the two semiconductor devices 300 are fastened and electrically connected to each other.

The semiconductor structure 310 of the chip 100 may include a plurality of transistors. With continuous development of semiconductor technologies, a size of the transistor gradually decreases, and a size of the pad 321 also gradually decreases. Correspondingly, in the related technology, Cu (copper) is used as a material of the pad 321, and hybrid bonding (hybrid bonding, HB) is performed on the pads 321 of the two semiconductor devices 300, so that the two semiconductor devices 300 are electrically interconnected via the pads 321. The hybrid bonding technology requires a small area of the pad 321, so that the pads 321 with a small size can be connected. This can improve interconnection bandwidth between the two semiconductor devices 300.

In the process of connecting the Cu pads 321, the two semiconductor devices 300 are aligned with high precision and are in contact, to implement hybrid bonding. Then, annealing is performed. In the annealing process, the Cu pads 321 of the two semiconductor devices 300 expand when being heated, and press against each other, so that a contact area of the Cu pads 321 of the two semiconductor devices 300 can be increased, and Cu in the Cu pads 321 of the two semiconductor devices 300 can even diffuse into each other. This can implement good ohmic contact between the Cu pads 321 of the two semiconductor devices 300.

A bonding result of the Cu pads 321 is affected by a plurality of factors, which further affects a subsequent electrical test and reliability test of the chip 100. For example, factors that affect the bonding result of the Cu pads 321 include: surface roughness of the Cu pad, a surface oxide layer, and proportions of nano-twinned copper and small-grained copper in the Cu pad 321.

In the related technology, the following three manners may be used to implement bonding effect of the Cu pads 321.

Manner 1: Before the Cu pads 321 are bonded, the Cu pads 321 are preprocessed by using plasma, so that Cu in the Cu pads 321 is in an "excited state", and the Cu pads 321 of the two semiconductor devices 300 are more easily combined. In the manner 1, a high-vacuum plasma bombardment device needs to be used. However, the high-vacuum plasma bombardment device is expensive, and consequently, costs of the manner 1 are high.

Manner 2: Before the Cu pads 321 are bonded, an acid solution is used to clean bonding surfaces of the Cu pads 321, to remove oxide layers on the bonding surfaces of the Cu pads 321, and improve interfacial energy of the Cu pads 321. It should be noted that the bonding surface of the Cu pad 321 is a surface that is of the Cu pad 321 and that is away from the semiconductor structure 310. However, in the manner 2, after the bonding surface of the Cu pad 321 is pickled, there may be some gaps between the bonding surfaces of the Cu pads 321. Consequently, contact effect of the two Cu pads 321 is affected, and bonding effect of the Cu pads 321 is affected.

Manner 3: ECP conditions are adjusted, to increase the proportions of nano-twinned copper and small-grained copper. It should be noted that the Cu pad 321 may be formed by using an electrochemical deposition (electrochemical deposition, ECP) process. A proportion of nano-twinned copper is approximately 40%, and a diffusion coefficient of nano-twinned copper is high. Therefore, a higher proportion of nano-twinned copper indicates better bonding effect of the two Cu pads 321. However, nano-twinned copper usually appears at an edge of the Cu pad 321, and the proportion of nano-twinned copper is usually less than 40% of an area of the bonding surfaces of the Cu pads 321. Consequently, the proportion of nano-twinned copper is low, and bonding effect of the Cu pads 321 of the two semiconductor devices 300 is poor. The ECP conditions are adjusted, to implement a large area of nano-twinned copper on a bonding surface of a small Cu pad 321, which poses large challenges.

In conclusion, when the manner 1, the manner 2, and the manner 3 are applied to hybrid bonding of the Cu pads 321, bonding effect of the Cu pads 321 is poor, and consequently, results of the electrical test and the reliability test of the chip 100 are poor.

In view of this, an embodiment of this application provides a chip.

FIG. 3 is a diagram of a structure of a chip 100 according to an embodiment of this application.

Refer to FIG. 3. The chip 100 may include two semiconductor devices 300. The semiconductor device 300 includes a semiconductor structure 310 and an interconnection layer 330. The interconnection layer 330 is located on a side of the semiconductor structure 310, the interconnection layer 330 includes a plurality of bonding portions 340 that are spaced apart, the bonding portion 340 includes a bonding pad 341 and a metal glass layer 342, the bonding pad 341 is connected to the semiconductor structure 310, and the metal glass layer 342 covers a side that is of the bonding pad 341 and that is away from the semiconductor structure 310. Metal glass layers 342 of a plurality of bonding portions 340 of the two semiconductor devices 300 are bonded, to form a plurality of bonding connection portions 400.

In FIG. 3, a structure within a dashed box indicated by a number 400 is the bonding connection portion 400. The dashed box indicated by the number 400 merely indicates a position of the bonding connection portion 400, and does not indicate an actual boundary of the bonding connection portion 400.

In one semiconductor device 300, the semiconductor structure 310 and the interconnection layer 330 are stacked in a first direction F1. As shown in FIG. 3, for the lower semiconductor device 300, a direction indicated by an arrow F1 is the first direction F1. The first direction F1 may be perpendicular to the interconnection layer 330. However, for the other semiconductor device 300, namely, the upper semiconductor device 300, a first direction corresponding to the upper semiconductor device 300 is opposite to the first direction F1 corresponding to the lower semiconductor device 300.

In some examples, the semiconductor structure 310 may include a functional structure 311, a spacer layer 312, and a routing layer 313.

The functional structure 311 may include a functional device, and the functional device is configured to implement a function of the semiconductor device 300. In the chip 100, functions of the two semiconductor devices 300 may be different.

For example, when the chip 100 is a NAND memory, the functional device of the functional structure 311 of one semiconductor device 300 may be a memory cell string, and the memory cell string may implement a storage function. The functional device of the functional structure 311 of the other semiconductor device 300 may be a logic circuit or a storage circuit.

The spacer layer 312 may be made of an insulation material. For example, a material of the spacer layer 312 may include an oxide, for example, SiO₂ (silicon dioxide). In addition, the material of the spacer layer 312 may alternatively include SiOCN (silicon oxycarbonitride).

A material of the routing layer 313 may include a conductive material. For example, the conductive material may include a metal material. The routing layer 313 may be electrically connected to the functional device of the functional structure 311. A structure of the electrical connection between the routing layer 313 and the functional device is not shown in FIG. 3.

The routing layer 313 may include a plurality of metal traces.

In some examples, the semiconductor structure 310 may further include a substrate (not shown in FIG. 3), and the substrate may be disposed on a side that is of the functional structure 311 and that is away from the routing layer 313.

For example, the substrate may be made of silicon or another semiconductor material. For example, the substrate includes one or a combination of the following materials: silicon, silicon carbide, and gallium nitride. Optionally or additionally, the substrate may include a semiconductor material of an element like germanium. In some examples, the substrate is made of a compound semiconductor, for example, silicon carbide, gallium arsenide, indium arsenide, or indium phosphide. In some examples, the substrate is made of an alloy semiconductor, for example, silicon germanium, silicon carbide alloyed with germanium, gallium arsenide phosphide, or indium gallium phosphide.

The plurality of bonding portions 340 of the interconnection layer 330 are spaced apart, so that the plurality of bonding portions 340 are insulated from each other. The bonding pad 341 of the bonding portion 340 may be made of a metal material. For example, a material of the bonding pad 341 may include at least one of gold, silver, copper, aluminum, titanium, molybdenum, tungsten, nickel, and chromium. The material of the bonding pad 341 may be adjusted as required, and the material of the bonding pad 341 is not limited in embodiments of this application.

For example, the bonding pad 341 may be electrically connected to the metal trace at the routing layer 313. One metal trace may be electrically connected to at least one bonding pad 341.

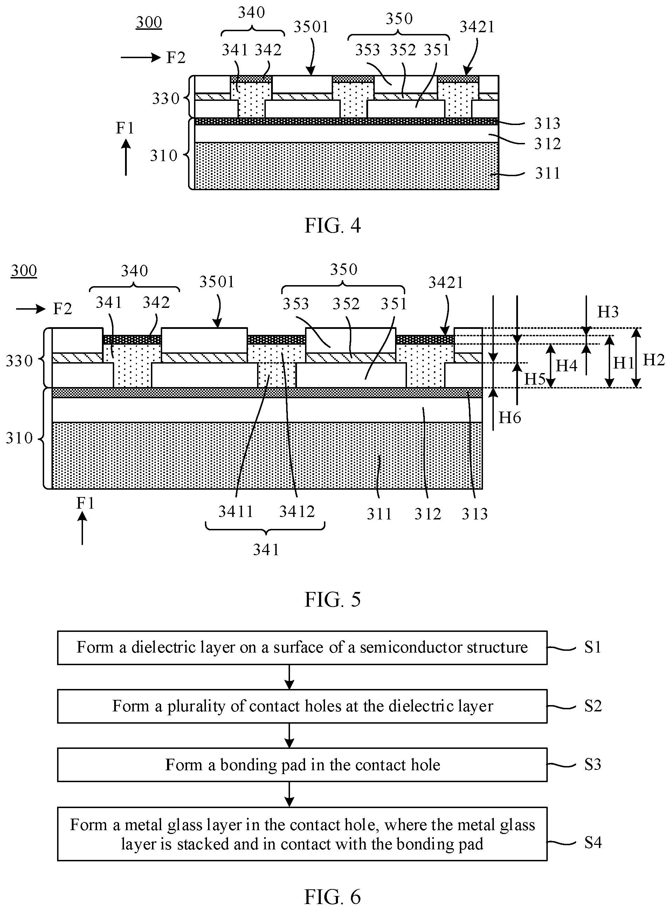

FIG. 4 is a diagram of a structure of a semiconductor device 300 according to an embodiment of this application.

Refer to FIG. 4. The metal glass layer 342 is conductive.

The metal glass layer 342 may be located on a side that is of the bonding pad 341 and that is away from the semiconductor structure 310, and the metal glass layer 342 is in contact with the bonding pad 341, so that the metal glass layer 342 may be electrically connected to the bonding pad 341, and the metal glass layer 342 may be electrically connected to the semiconductor structure via the bonding pad 341.

Refer to both FIG. 4 and FIG. 3. After the metal glass layers 342 of the two semiconductor devices 300 are bonded, the metal glass layers 342 of the two semiconductor devices 300 may be bonded to form bonding connection portions 400. A quantity of bonding portions 340 included in the two semiconductor devices 300 may be the same. For example, each semiconductor device 300 may include N1 bonding portions 340, and metal glass layers 342 of the N1 bonding portions 340 of one semiconductor device 300 may be bonded to metal glass layers 342 of the N1 bonding portions 340 of the other semiconductor device 300 in a one-to-one correspondence, to form N1 bonding connection portions 400. N1 is a positive integer greater than or equal to 1.

The semiconductor structure 310 of one semiconductor device 300 may be electrically connected to the bonding connection portion 400 via the bonding pad 341 of the semiconductor device 300, and the bonding connection portion 400 may be electrically connected to the semiconductor structure 310 of the other semiconductor device 300 via the bonding pad 341 of the other semiconductor device 300, so that the semiconductor structures 310 of the two semiconductor devices 300 can be electrically connected for information exchange.

The metal glass layer 342 has a liquid-like property at a high temperature. Specifically, when the metal glass layer 342 is at a temperature between a glass transition temperature and a crystallization temperature, a Young's modulus of the metal glass layer 342 decreases, and hardness decreases, so that the metal glass layer 342 softens. In this case, a property of the metal glass layer 342 is similar to that of a liquid. A temperature range between the glass transition temperature and the crystallization temperature is referred to as a supercooled liquid phase region. In this case, because the metal glass layer 342 does not reach a melting point, the metal glass layer 342 is not melted.

In a bonding process of the metal glass layers 342 of bonding portions 340 of the two semiconductor devices 300, the metal glass layers 342 of the bonding portions 340 of the two semiconductor devices 300 are aligned with high precision, and then hybrid bonding and annealing are performed. In the annealing process, when a temperature reaches the supercooled liquid phase region, the metal glass layers 342 of the two semiconductor devices 300 may be softened to form a liquid-like state. This can generate effect similar to liquid flowing, reduce a gap between contact interfaces of the metal glass layers 342 of the two semiconductor devices 300, improve contact effect of the metal glass layers 342 of the two semiconductor devices 300, improve bonding effect of the two semiconductor devices 300, improve electrical connection quality of the two semiconductor devices 300, and improve a subsequent electrical test and reliability test of the chip 100.

In addition, before the metal glass layers 342 of the two semiconductor devices 300 are bonded, an oxide layer may exist on a surface of the metal glass layer 342. The metal glass layer 342 is of an amorphous structure (that is, a non-crystal structure) in microscope. At the metal glass layer 342, because metal atoms are not at positions with lowest energy, the metal atoms are in a high energy state in terms of structure. In this case, the metal glass layer 342 may excite motion of local metal atomic clusters of the metal glass layer 342 through ultrasonic vibration at a normal temperature, and the motion of the atomic clusters may enable the atomic clusters to break through an oxide layer on a bonding interface of the metal glass layer 342, so that the metal glass layers 342 of the two semiconductor devices 300 may break through oxide layers on the surfaces for bonding. Therefore, bonding effect of the metal glass layers 342 of the two semiconductor devices 300 is good. In addition, because the motion of the atomic clusters at the metal glass layer 342 can break through the oxide layer on the surface at the normal temperature, the metal glass layers 342 of the two semiconductor devices 300 can be bonded at the normal temperature.

In addition, after hybrid bonding is performed on the metal glass layers 342 of the two semiconductor devices 300, in the annealing process, the motion of the metal atomic clusters is more intense. This helps the metal atomic clusters break through the oxide layer on the bonding interface of the metal glass layer 342, to improve bonding effect of the metal glass layers 342 of the two semiconductor devices 300.

In some examples, the annealing temperature may be greater than or equal to 250°C and less than or equal to 450°C. In this case, the annealing temperature is low, but the metal glass layers 342 of the two semiconductor devices 300 can achieve good bonding effect.

For example, the annealing temperature may be about 300°C.

The following describes the semiconductor device 300.

Still refer to FIG. 4. In this embodiment, the interconnection layer 330 further includes a dielectric layer 350. The bonding portion 340 is embedded in the dielectric layer 350. In this case, both the bonding pad 341 and the metal glass layer 342 of the bonding portion 340 are embedded in the dielectric layer 350.

Projection of the bonding pad 341 in a second direction F2 covers a part of the dielectric layer 350, and projection of the metal glass layer 342 in the second direction F2 covers a part of the dielectric layer 350. The second direction F2 is parallel to a surface that is of the dielectric layer 350 and that is away from the semiconductor structure 310. As shown in FIG. 4, a direction indicated by an arrow F2 is the second direction F2. It should be noted that there are a plurality of directions parallel to the surface that is of the dielectric layer 350 and that is away from the semiconductor structure 310, and the second direction F2 may be any direction parallel to the surface that is of the dielectric layer 350 and that is away from the semiconductor structure 310.

The dielectric layer 350 exposes a first surface 3421 of the metal glass layer 342, and the first surface 3421 is a surface that is of the metal glass layer 342 and that is away from the semiconductor structure 310. The dielectric layer 350 does not cover the first surface 3421 of the metal glass layer 342.

The dielectric layer 350 includes a second surface 3501 that is away from the semiconductor structure 310.

In some examples, the first surface 3421 of the metal glass layer 342 and the second surface 3501 of the semiconductor structure 310 may be located on a same surface.

FIG. 5 is a diagram of another structure of a semiconductor device 300 according to an embodiment of this application.

Refer to FIG. 5. In some other examples, the first surface 3421 is closer to the semiconductor structure 310 than the second surface 3501.

A distance between the first surface 3421 and the semiconductor structure 310 in the first direction F1 is a first distance H1, and a distance between the second surface 3501 and the semiconductor structure 310 in the first direction F1 is a second distance H2. The first distance H1 is less than the second distance H2.

In this example, the metal glass layer 342 is recessed in the dielectric layer 350. In this case, the first surface 3421 of the metal glass layer 342 and the dielectric layer 350 may form expansion space. In the bonding process of the metal glass layers 342 of the bonding portions 340 of the two semiconductor devices 300, the metal glass layers 342 of the two semiconductor devices 300 may expand, and sizes of the metal glass layers 342 may increase. The first surface 3421 of the metal glass layer 342 and the dielectric layer 350 enclose the expansion space, so that the metal glass layer 342 may expand into the expansion space. This avoids a gap between the bonded metal glass layers 342 of the two semiconductor devices 300 due to excessive protrusion of the expanded metal glass layer 342 from the second surface 3501 of the dielectric layer 350. In embodiments of this application, the first surface 3421 is closer to the semiconductor structure 310 than the second surface 3501, to avoid a gap between the two bonded semiconductor devices 300 due to expansion of the metal glass layers 342.

In some embodiments, a distance between the first surface 3421 and the second surface 3501 in the first direction F1 is greater than or equal to 20 Å and less than or equal to 300 Å, and the first direction F1 is perpendicular to the first surface 3421. In other words, a depth of the expansion space in the first direction F1 is greater than or equal to 20 Å and less than or equal to 300 Å.

A larger distance between the first surface 3421 and the second surface 3501 in the first direction F1 indicates a larger volume of the expansion space, and a smaller distance between the first surface 3421 and the second surface 3501 in the first direction F1 indicates a smaller volume of the expansion space.

In embodiments of this application, the distance between the first surface 3421 and the second surface 3501 in the first direction F1 is greater than or equal to 20 Å, so that the metal glass layer 342 has sufficient expansion space. This avoids a gap between the bonded metal glass layers 342 of the two semiconductor devices 300 due to excessive protrusion of the expanded metal glass layer 342 from the second surface 3501 caused by insufficient expansion space, so that bonding effect of the metal glass layers 342 of the two semiconductor devices 300 is not affected. Therefore, the distance between the first surface 3421 and the second surface 3501 in the first direction F1 is greater than or equal to 20 Å, to avoid a gap between the two semiconductor devices 300 after the metal glass layers 342 are bonded.

The distance between the first surface 3421 and the second surface 3501 in the first direction F1 is less than or equal to 300 Å, to avoid a case in which the expansion space cannot be filled with the expanded metal glass layer 342 due to the expansion space of the metal glass layer 342 being excessively large. If the expansion space is excessively large, a gap exists between the metal glass layers 342 of the two semiconductor devices 300 after expansion, and contact effect of the metal glass layers 342 of the two semiconductor devices 300 is affected. Therefore, the distance between the first surface 3421 and the second surface 3501 in the first direction F1 is less than or equal to 300 Å, to reduce impact of excessively large expansion space on bonding effect of the metal glass layers 342 of the two semiconductor devices 300.

In some examples, the distance between the first surface 3421 and the second surface 3501 in the first direction F1 is equal to 200 Å. Therefore, this can prevent bonding effect of the metal glass layers 342 of the two semiconductor devices 300 from being affected due to excessive protrusion of the expanded metal glass layer 342 from the second surface 3501 caused by insufficient expansion space, and can prevent bonding effect of the metal glass layers 342 of the two semiconductor devices 300 from being affected due to the metal glass layers 342 of the two semiconductor devices 300 not being in full contact caused by the excessively large expansion space.

Still refer to FIG. 5. In some embodiments, the dielectric layer 350 includes a first isolation layer 351, an intermediate layer 352, and a second isolation layer 353 that are sequentially stacked on the semiconductor structure 310. The second surface 3501 of the dielectric layer 350 is a surface that is of the second isolation layer 353 and that is away from the intermediate layer 352.

The first isolation layer 351 has an insulation feature, and may be made of an insulation material. For example, a material of the first isolation layer 351 may include an oxide (oxide), for example, SiO₂ (silicon dioxide). In addition, the material of the first isolation layer 351 may alternatively include silicon oxycarbonitride.

In some examples, thickness of the first isolation layer 351 may be greater than or equal to 5000 Å and less than or equal to 15000 Å.

For example, the thickness of the first isolation layer 351 may be equal to 6500 Å.

A material of the intermediate layer 352 may include SiN (silicon nitride).

In some examples, thickness of the intermediate layer 352 may be greater than or equal to 700 Å and less than or equal to 2000 Å.

For example, the thickness of the intermediate layer 352 may be equal to 1000 Å.

The second isolation layer 353 has an insulation feature, and may be made of an insulation material. For example, a material of the second isolation layer 353 may include an oxide (oxide), for example, SiO₂ (silicon dioxide). In addition, the material of the second isolation layer 353 may alternatively include silicon oxycarbonitride.

In some examples, thickness of the second isolation layer 353 may be greater than or equal to 5000 Å and less than or equal to 15000 Å.

For example, the thickness of the second isolation layer 353 may be equal to 6500 Å.

The bonding pad 341 is embedded in the first isolation layer 351, the intermediate layer 352, and the second isolation layer 353, and the metal glass layer 342 is embedded in the second isolation layer 353.

The projection of the bonding pad 341 in the second direction F2 covers the first isolation layer 351, the intermediate layer 352, and a part of the second isolation layer 353, and the projection of the metal glass layer 342 in the second direction F2 covers a part of the second isolation layer 353. The second direction F2 is parallel to the second surface 3501.

Still refer to FIG. 5. In some embodiments, a ratio of thickness H4 of the bonding pad 341 to thickness H3 of the metal glass layer 342 is greater than or equal to 10.55 and less than or equal to 158.9, that is, 10.55≤H4/H3≤158.9.

H4/H3 is greater than or equal to 10.55, to prevent the thickness H3 of the metal glass layer 342 from being excessively large. If the thickness of the metal glass layer 342 is excessively large, the expanded metal glass layer 342 may excessively protrude from the second surface 3501. In this case, there may be a gap between the two semiconductor devices 300 after the metal glass layers 342 of the two semiconductor devices 300 are bonded. Therefore, H4/H3 is greater than or equal to 10.55, to avoid a gap between the two semiconductor devices 300 due to the thickness of the metal glass layer 342 being excessively large.

In addition, H4/H3 is less than or equal to 158.9, to prevent the thickness H3 of the metal glass layer 342 from being excessively small. If the thickness of the metal glass layer 342 is excessively small, there may be a gap between the metal glass layers 342 of the two semiconductor devices 300 after the metal glass layers 342 of the two semiconductor devices 300 expand, and consequently, the metal glass layers 342 of the two semiconductor devices 300 are not fully combined. Therefore, H4/H3 is less than or equal to 158.9, to avoid a case in which the metal glass layers 342 of the two semiconductor devices 300 are not fully combined due to the thickness of the metal glass layer 342 being excessively small.

For example, the ratio of the thickness H4 of the bonding pad 341 to the thickness H3 of the metal glass layer 342 is greater than or equal to 21.67 and less than or equal to 26.

In some embodiments, the thickness H4 of the bonding pad 341 is greater than or equal to 9500 Å and less than or equal to 317800 Å.

The thickness H4 of the bonding pad 341 is greater than or equal to 9500 Å, to prevent the thickness of the metal glass layer 342 on the surface of the bonding pad 341 from being excessively large due to the thickness H4 of the bonding pad 341 being excessively small. If the thickness of the metal glass layer 342 is excessively large, the expanded metal glass layer 342 may excessively protrude from the second surface 3501. In this case, there may be a gap between the two semiconductor devices 300 after the metal glass layers 342 of the two semiconductor devices 300 are bonded. Therefore, the thickness H4 of the bonding pad 341 is greater than or equal to 9500 Å, to avoid a gap between the two semiconductor devices 300 due to the thickness of the metal glass layer 342 being excessively large.

The thickness H4 of the bonding pad 341 is less than or equal to 31780 Å, to prevent the thickness of the metal glass layer 342 on the surface of the bonding pad 341 from being excessively small due to the thickness H4 of the bonding pad 341 being excessively large. If the thickness of the metal glass layer 342 is excessively small, there may be a gap between the metal glass layers 342 of the two semiconductor devices 300 after the metal glass layers 342 of the two semiconductor devices 300 expand, and consequently, the metal glass layers 342 of the two semiconductor devices 300 are not fully combined. Therefore, the thickness H4 of the bonding pad 341 is less than or equal to 31780 Å, to avoid a case in which the metal glass layers 342 of the two semiconductor devices 300 are not fully combined due to the thickness of the metal glass layer 342 being excessively small.

For example, the thickness H4 of the bonding pad 341 is equal to 12750 Å. Therefore, this can avoid a gap between the two semiconductor devices 300 due to the thickness of the metal glass layer 342 being excessively large, and can avoid a case in which the metal glass layers 342 of the two semiconductor devices 300 are not fully combined due to the thickness of the metal glass layer 342 being excessively small.

Still refer to FIG. 5. In some embodiments, the bonding pad 341 includes a first part 3411 and a second part 3412, and one end of the first part 3411 is connected to the semiconductor structure 310. The second part 3412 is connected to the other end of the first part 3411. For example, one end of the first part 3411 may be electrically connected to the routing layer 313.

A cross-sectional area of the first part 3411 on a first reference plane is less than a cross-sectional area of the second part 3412 on a second reference plane, and both the first reference plane and the second reference plane are parallel to the surface that is of the metal glass layer 342 and that is away from the semiconductor structure 310. In other words, both the first reference plane and the second reference plane are parallel to the first surface 3421 of the metal glass layer 342, the first reference plane passes through the first part 3411, and the second reference plane passes through the second part 3412.

Density of metal traces at the routing layer 313 is large. The first part 3411 with a small cross-sectional area is disposed in the bonding pad 341, to facilitate connection between the first part 3411 and the metal traces.

However, the second part 3412 has a large cross-sectional area, and the metal glass layer 342 is disposed on a side that is of the second part 3412 and that is away from the first part 3411. An area of a bearing surface of the second part 3412 may further increase an area of the metal glass layer 342, to increase a contact area of the metal glass layers 342 of the two semiconductor devices 300. This can improve bonding effect of the metal glass layers 342 of the two semiconductor devices 300. The bearing surface of the second part 3412 is a surface that is of the second part 3412 and that is connected to the metal glass layer 342.

A ratio of thickness H5 of the first part 3411 to the thickness H3 of the metal glass layer 342 is greater than or equal to 5.55 and less than or equal to 75, that is, 5.55≤H5/H3≤75.

H5/H3 is greater than or equal to 5.55, to prevent the thickness H3 of the metal glass layer 342 from being excessively large. If the thickness of the metal glass layer 342 is excessively large, the expanded metal glass layer 342 may excessively protrude from the second surface 3501. In this case, there may be a gap between the two semiconductor devices 300 after the metal glass layers 342 of the two semiconductor devices 300 are bonded. Therefore, H5/H3 is greater than or equal to 5.55, to avoid a gap between the two semiconductor devices 300 due to the thickness of the metal glass layer 342 being excessively large.

In addition, H5/H3 is less than or equal to 75, to prevent the thickness H3 of the metal glass layer 342 from being excessively small. If the thickness of the metal glass layer 342 is excessively small, there may be a gap between the metal glass layers 342 of the two semiconductor devices 300 after the metal glass layers 342 of the two semiconductor devices 300 expand, and consequently, the metal glass layers 342 of the two semiconductor devices 300 are not fully combined. Therefore, H5/H3 is less than or equal to 75, to avoid a case in which the metal glass layers 342 of the two semiconductor devices 300 are not fully combined due to the thickness of the metal glass layer 342 being excessively small.

In some examples, the thickness H5 of the first part 3411 is greater than or equal to 5000 Å and less than or equal to 15000 Å.

For example, the thickness H5 of the first part 3411 is equal to 6500 Å.

A ratio of thickness H6 of the second part 3412 to the thickness H3 of the metal glass layer 342 is greater than or equal to 5 and less than or equal to 83.9, that is, 5≤H6/H3≤83.9.

H6/H3 is greater than or equal to 5, to prevent the thickness H3 of the metal glass layer 342 from being excessively large. If the thickness of the metal glass layer 342 is excessively large, the expanded metal glass layer 342 may excessively protrude from the second surface 3501. In this case, there may be a gap between the two semiconductor devices 300 after the metal glass layers 342 of the two semiconductor devices 300 are bonded. Therefore, H6/H3 is greater than or equal to 5, to avoid a gap between the two semiconductor devices 300 due to the thickness of the metal glass layer 342 being excessively large.

In addition, H6/H3 is less than or equal to 83.9, to prevent the thickness H3 of the metal glass layer 342 from being excessively small. If the thickness of the metal glass layer 342 is excessively small, there may be a gap between the metal glass layers 342 of the two semiconductor devices 300 after the metal glass layers 342 of the two semiconductor devices 300 expand, and consequently, the metal glass layers 342 of the two semiconductor devices 300 are not fully combined. Therefore, H6/H3 is less than or equal to 83.9, to avoid a case in which the metal glass layers 342 of the two semiconductor devices 300 are not fully combined due to the thickness of the metal glass layer 342 being excessively small.

In some examples, the thickness H6 of the second part 3412 is greater than or equal to 4500 Å and less than or equal to 16780 Å.

For example, the thickness H6 of the second part 3412 is equal to 6500 Å.

In some embodiments, the thickness H3 of the metal glass layer 342 is greater than or equal to 200 Å and less than or equal to 900 Å.

The thickness H3 of the metal glass layer 342 is greater than or equal to 200 Å, to prevent the thickness H3 of the metal glass layer 342 from being excessively small. If the thickness of the metal glass layer 342 is excessively small, there may be a gap between the metal glass layers 342 of the two semiconductor devices 300 after the metal glass layers 342 of the two semiconductor devices 300 expand, and consequently, the metal glass layers 342 of the two semiconductor devices 300 are not fully combined. Therefore, the thickness H3 of the metal glass layer 342 is greater than or equal to 200 Å, to avoid a case in which the metal glass layers 342 of the two semiconductor devices 300 are not fully combined due to the thickness of the metal glass layer 342 being excessively small.

In addition, the thickness H3 of the metal glass layer 342 is less than or equal to 900 Å, to prevent the thickness H3 of the metal glass layer 342 from being excessively large. If the thickness H3 of the metal glass layer 342 is excessively large, the expanded metal glass layer 342 may excessively protrude from the second surface 3501. In this case, there may be a gap between the two semiconductor devices 300 after the metal glass layers 342 of the two semiconductor devices 300 are bonded. Therefore, the thickness H3 of the metal glass layer 342 is less than or equal to 900 Å, to avoid a gap between the two semiconductor devices 300 due to the thickness of the metal glass layer 342 being excessively large.

In some examples, the thickness H3 of the metal glass layer 342 is greater than or equal to 500 Å and less than or equal to 600 Å, to avoid a case in which the metal glass layers 342 of the two semiconductor devices 300 are not fully combined due to the thickness of the metal glass layer 342 being excessively small, and avoid a gap between the two semiconductor devices 300 due to the thickness of the metal glass layer 342 being excessively large.

In some embodiments, a material of the metal glass layer 342 includes CuZr (copper zirconium).

After the metal glass layers 342 of the two semiconductor devices 300 are bonded, during annealing of the two semiconductor devices 300, when an annealing temperature reaches a crystallization temperature of CuZr, Cu atoms in CuZr may be crystallized, and single-crystal Cu is precipitated. In other words, the bonding connection portions 400 formed after the metal glass layers 342 of the two semiconductor devices 300 are bonded may include CuZr and single-crystal Cu. Resistivity of single-crystal Cu is less than resistivity of CuZr. Therefore, the material of the metal glass layer 342 includes CuZr, to reduce resistivity of the bonding connection portion 400.

In some examples, the resistivity of the bonding connection portion 400 is about 10E-7 Ωm.

In some examples, a resistance value of the metal bonding connection portion 400 is about 0.0002 Ω.

In some examples, a material of the metal glass layer 342 includes Cu_{X}Zr_{100-X}. A ratio of Cu atoms to Zr atoms in the metal glass layer 342 is X:100-X. X is greater than or equal to 30 and less than or equal to 90.

X is greater than or equal to 30, to avoid a small amount of formed single-crystal Cu due to an excessively small proportion of Cu atoms in the metal glass layer 342. A smaller proportion of single-crystal Cu indicates larger resistivity of the bonding connection portion 400 formed after the metal glass layers 342 of the two semiconductor devices 300 are bonded. Therefore, X is greater than or equal to 30, to prevent the resistivity of the bonding connection portion 400 from being excessively large due to an excessively small proportion of Cu atoms.

In addition, X is greater than or equal to 90, to avoid a case in which properties of the metal glass layer 342 are close to those of the Cu bonding pad 341 due to an excessively large proportion of Cu atoms in the metal glass layer 342. Therefore, bonding effect of the metal glass layers 342 of the two semiconductor devices 300 is not affected.

For example, X=85, and 100-X=15. In this case, the material of the metal glass layer 342 includes Cu85Zr15.

In some embodiments above, the semiconductor device 300 provided in embodiments of this application is described with reference to FIG. 4 and FIG. 5. The following describes a chip 100 formed after the two semiconductor devices 300 are bonded.

Still refer to FIG. 3. In some embodiments, in the semiconductor device 300, there is a recess on a surface that is of the bonding pad 341 of the bonding portion 340 and that is away from the semiconductor structure 310 of the semiconductor device 300, and the recess is filled with a part of the bonding connection portion 400.

The surface that is of the bonding pad 341 and that is away from the semiconductor structure 310 is not a smooth surface, and has the recess. In a process of bonding the metal glass layers 342 of the two semiconductor devices 300, a temperature of the metal glass layer 342 increases. When the temperature reaches a supercooled liquid phase region, the metal glass layer 342 is in a liquid-like state. Therefore, the metal glass layer 342 may be fluid, and the recess on the surface that is of the bonding pad 341 and that is away from the semiconductor structure 310 may be filled with the metal glass layer 342, to increase connection effect between the metal glass layer 342 (namely, the bonding connection portion 400) and the bonding pad 341.

The following describes a preparation method for the semiconductor device 300.

FIG. 6 is a flowchart of a preparation method for a semiconductor device according to an embodiment of this application.

Refer to FIG. 6. The preparation method for the semiconductor device includes step S1 to step S4.

S1: Form a dielectric layer on a surface of a semiconductor structure.

A structure of the semiconductor structure 310 has been described in some of the foregoing embodiments. Details are not described herein again.

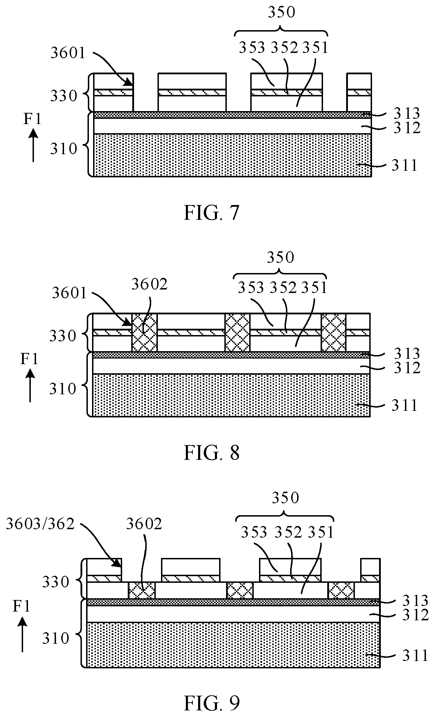

FIG. 7 to FIG. 14 are diagrams of steps of a preparation method for a semiconductor device according to an embodiment of this application.

Refer to FIG. 7 to FIG. 10. In some examples, the dielectric layer 350 may include the first isolation layer 351, the intermediate layer 352, and the second isolation layer 353. Materials of the first isolation layer 351, the intermediate layer 352, and the second isolation layer 353 are described in some of the foregoing embodiments. Details are not described herein again.

When the dielectric layer 350 is formed, the first isolation layer 351 may be formed on the surface of the routing layer 313 of the semiconductor structure 310.

Then, the intermediate layer 352 is formed on a surface that is of the first isolation layer 351 and that is away from the semiconductor structure 310.

Next, the second isolation layer 353 is formed on a surface that is of the intermediate layer 352 and that is away from the semiconductor structure 310.

The first isolation layer 351, the intermediate layer 352, and the second isolation layer 353 may be formed by using a thin film deposition process. For example, the thin film deposition process may include one or a combination of a chemical vapor deposition (chemical vapor deposition, CVD) process, a physical vapor deposition (physical vapor deposition, PVD) process, an atomic layer deposition (atomic layer deposition, ALD) process, and an electrochemical deposition (electrochemical deposition, ECP) process.

S2: Form a plurality of contact holes at the dielectric layer.

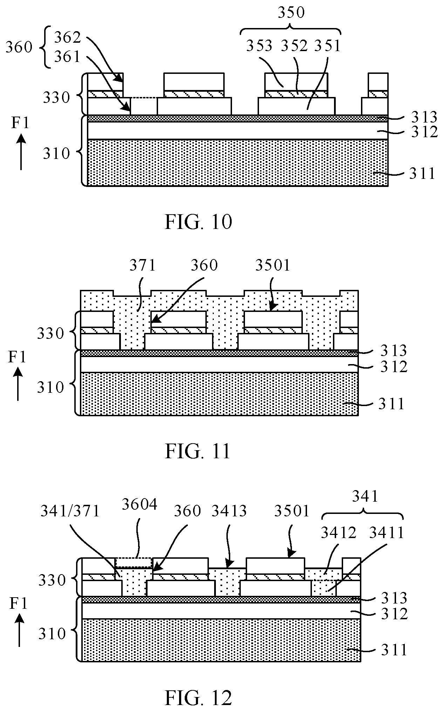

Refer to FIG. 10. In some examples, the contact hole 360 may be a stepped hole. For example, the contact hole 360 may include a first section 361 of the hole and a second section 362 of the hole. The first section 361 of the hole and the second section 362 of the hole communicate with each other, and are sequentially disposed in the first direction F1. The first section 361 of the hole penetrates the first isolation layer 351, and the second section 362 of the hole penetrates the intermediate layer 352 and the second isolation layer 353. The first section 361 of the hole exposes the routing layer 313 of the semiconductor structure 310.

A cross-sectional area of the first section 361 of the hole is less than a cross-sectional area of the second section 362 of the hole. The cross-sectional area of the first section 361 of the hole is a cross-sectional area of the first section 361 of the hole on a first reference plane. The cross-sectional area of the second section 362 of the hole is a cross-sectional area of the second section 362 of the hole on a second reference plane. Both the first reference plane and the second reference plane are perpendicular to the first direction F1. The first reference plane passes through the first section 361 of the hole, and the second reference plane passes through the second section 362 of the hole.

Step S2 may include step S21 to step S24.

Refer to FIG. 7. S21: Form a plurality of first sections 3601 of the hole at the dielectric layer 350, where the first sections 3601 of the hole penetrate the first isolation layer 351, the intermediate layer 352, and the second isolation layer 353. A cross-sectional area of the first section 3601 of the hole may be equal to the cross-sectional area of the first section 361 of the hole.

In some examples, in step S21, the first sections 3601 of the hole may be formed by using an etching process.

Refer to FIG. 8. S22: Fill the plurality of first sections 3601 of the hole with sacrificial media 3602.

Refer to FIG. 9. S23: Form a plurality of second sections 3603 of the hole at the dielectric layer 350, where the second sections 3603 of the hole penetrate the intermediate layer 352 and the second isolation layer 353. In a process of forming the second sections 3603 of the hole, the sacrificial media 3602 located in the intermediate layer 352 and the sacrificial media 3602 located in the second isolation layer 353 are removed.

The second section 3603 of the hole may be used as the second section 362 of the hole.

For example, in step S23, the second sections 3603 of the hole may be formed by using the etching process. In step S23, the sacrificial media 3602 located in the first isolation layer 351 is retained.

Refer to FIG. 10. S24: Remove the sacrificial media 3602 (as shown in FIG. 9) located in the first isolation layer 351, to form the contact hole 360. For example, in step S24, the sacrificial media 3602 in the first isolation layer 351 may be removed by using the etching process.

The plurality of contact holes are formed by using step S21 to step S24.

The contact hole 360 provided in FIG. 10 is a stepped hole. In some other examples, a cross-sectional area of the contact hole 360 may remain unchanged in the first direction F1. Alternatively, a cross-sectional area of the contact hole 360 may gradually increase in the first direction F1.

S3: Form a bonding pad in the contact hole.

Refer to FIG. 12. The bonding pad 341 includes the first part 3411 and the second part 3412, and one end of the first part 3411 is connected to the semiconductor structure 310. The second part 3412 is connected to the other end of the first part 3411. The first part 3411 and the second part 3412 may be formed in a same process.

Structures of the first part 3411 and the second part 3412 has been described in some of the foregoing embodiments. Details are not described herein again.

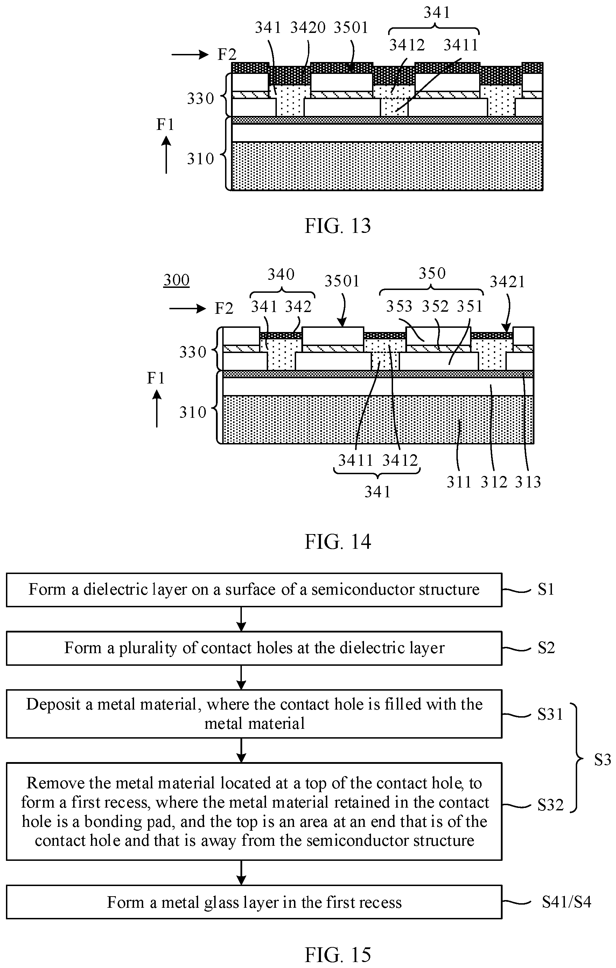

FIG. 15 is another flowchart of a preparation method for a semiconductor device according to an embodiment of this application.

Refer to FIG. 15. Step S3 may include step S31 and step S32.

S31: Deposit a metal material, where the contact hole is filled with the metal material.

Refer to FIG. 11. In step S31, the contact hole 360 may be filled with the metal material 371, and the metal material 371 may also cover the surface that is of the dielectric layer 350 and that is away from the semiconductor structure 310, that is, cover the second surface 3501.

The metal material may include at least one of gold, silver, copper, aluminum, titanium, molybdenum, tungsten, nickel, and chromium.

In step S31, the contact hole 360 may be filled with the metal material 371 by using the thin film deposition process. For example, the thin film deposition process may include one or more of the chemical vapor deposition method, the physical vapor deposition method, the atomic layer deposition method, and the electrochemical deposition method.

In step S31, the contact hole 360 may be fully filled with the metal material 371, and a part of the metal material may protrude from the contact hole 360.

S32: Remove the metal material located at a top of the contact hole, to form a first recess, where the metal material retained in the contact hole is the bonding pad, and the top is an area at an end that is of the contact hole and that is away from the semiconductor structure.

Refer to FIG. 12. In step S32, both the metal material 371 located at the top of the contact hole 360 and the metal material 371 located on the second surface 3501 of the dielectric layer 350 are removed. In this case, the metal material retained in the contact hole 360 may be used as the bonding pad 341.

The metal material on the second surface 3501 of the dielectric layer 350 and the metal material on the top of the contact hole 360 may be removed by using a polish process.

For example, the polish process may include a chemical mechanical polish (chemical mechanical polish, CMP) process.

After step S32, the bonding pad 341 is formed. The bonding pad 341 includes a third surface 3413 that is away from the semiconductor structure 310, and the dielectric layer 350 includes the second surface 3501 that is away from the semiconductor structure 310. After step S32, the third surface 3413 is closer to the semiconductor structure 310 than the second surface 3501. In this case, the third surface 3413 of the bonding pad 341 and the top area of the contact hole 360 may form a first recess 3604. The first recess 3604 is a part of the contact hole 360.

In step S32, the first recess 3604 may be formed, to provide accommodation space for the metal glass layer 342. In addition, after the metal material located at the top of the contact hole is removed, the bonding pad 341 may be formed. In this case, the side that is of the bonding pad 341 and that is away from the semiconductor structure 310 may have a flat surface.

The metal material 371 on the second surface 3501 of the dielectric layer 350 may be removed by using the polish process, and then the metal material 371 on the top of the contact hole 360 is removed. When the metal material 371 on the top of the contact hole 360 is removed, a depth of the first recess 3604 may be controlled by adjusting polish pressure and polish time in a polish process.

In some examples, the depth of the first recess 3604 in the first direction F1 is greater than or equal to 500 Å and less than or equal to 2000 Å.

The depth of the first recess 3604 in the first direction F1 is greater than or equal to 500 Å, to prevent the metal glass layer 342 disposed in the first recess 3604 from being excessively thin due to a shallow first recess 3604. Therefore, the metal glass layer 342 is thick enough. If the metal glass layer 342 is excessively thin, there may be a gap between the metal glass layer 342 and the metal glass layer 342 of the other semiconductor device 300 after the metal glass layers 342 expand. Consequently, the metal glass layers 342 of the two semiconductor devices 300 are not fully combined, which affects bonding effect of the metal glass layers 342 of the two semiconductor devices 300, and further affects electrical connection effect of the metal glass layers 342 of the two semiconductor devices 300.

The depth of the first recess 3604 in the first direction F1 is less than or equal to 2000 Å, to prevent the metal glass layer 342 disposed in the first recess 3604 from being excessively thick due to a deep first recess 3604. If the metal glass layer 342 is excessively thick, the expanded metal glass layer 342 may excessively protrude from the second surface 3501 of the dielectric layer 350. In this case, there may be a gap between the bonded metal glass layers 342 of the two semiconductor devices 300, which affects connection effect of the two semiconductor devices 300. In addition, an excessively thick metal glass layer 342 may cause a material waste.

For example, the depth of the first recess 3604 in the first direction F1 is equal to 1000 Å. In this case, the metal glass layer 342 may be thick enough, to ensure bonding effect of the metal glass layers 342 of the two semiconductor devices 300, and prevent the expanded metal glass layers 342 from flowing between the dielectric layers 350 of the two semiconductor devices 300 due to the metal glass layers 342 being excessively thick. Therefore, connection effect of the metal glass layers 342 of the two semiconductor devices 300 is not affected.

S4: Form a metal glass layer in the contact hole, where the metal glass layer is stacked and in contact with the bonding pad.

After step S3, step S4 may be performed. Refer to FIG. 14. The metal glass layer 342 may be formed in the contact hole 360, and formed on the surface that is of the bonding pad 341 and that is away from the semiconductor structure 310. In this case, the metal glass layer 342 is in contact with the bonding pad 341, and the metal glass layer 342 may be electrically connected to the bonding pad 341.

In conclusion, the semiconductor device 300 is prepared by using step S1 to step S4. The metal glass layer 342 of the semiconductor device 300 prepared by using step S1 to step S4 has a liquid-like property when the temperature reaches or approaches the supercooled liquid phase region. In a bonding process of the metal glass layers 342 of bonding portions 340 of the two semiconductor devices 300, the metal glass layers 342 of the two semiconductor devices 300 are aligned with high precision, and then hybrid bonding and annealing are performed. In the annealing process, when a temperature reaches or approaches the supercooled liquid phase region, the metal glass layers 342 of the two semiconductor devices 300 may be softened to form a liquid-like state. This can generate effect similar to liquid flowing, reduce a gap between contact interfaces of the metal glass layers 342 of the two semiconductor devices 300, improve contact effect of the metal glass layers 342 of the two semiconductor devices 300, improve bonding effect of the two semiconductor devices 300, and improve a subsequent electrical test and reliability test of the chip 100.

In addition, the metal glass layer 342 is of an amorphous structure (that is, a non-crystal structure) in microscope. At the metal glass layer 342, because metal atoms are not at positions with lowest energy, the metal atoms are in a high energy state in terms of structure. In this case, the metal glass layer 342 may excite motion of local metal atomic clusters of the metal glass layer 342 through ultrasonic vibration at a normal temperature, and the motion of the atomic clusters may enable the atomic clusters to break through an oxide layer on a bonding interface of the metal glass layer 342, so that combining effect of the metal glass layers 342 of the two semiconductor devices 300 is good. In addition, the metal glass layers 342 of the two semiconductor devices 300 may be bonded at a normal temperature.

In addition, in the annealing process, the motion of the metal atomic clusters is more intense. This helps the metal atomic clusters break through the oxide layer on the bonding interface of the metal glass layer 342, to improve bonding effect of the metal glass layers 342 of the two semiconductor devices 300.

Still refer to FIG. 15. In some examples, when the preparation method for the semiconductor device includes step S31 and step S32, step S4 may include step S41.

S41: Form the metal glass layer in the first recess.

After step S32, a side that is of the bonding pad 341 and that is away from the semiconductor structure 310 has a flat surface, to provide the flat surface for forming the metal glass layer. This helps improve thickness uniformity of the metal glass layer 342.

Still refer to FIG. 4. In some examples, the thickness of the metal glass layer 342 may be equal to the depth of the first recess 3604. Refer to FIG. 14. In some other examples, the thickness of the metal glass layer 342 may be less than the depth of the first recess 3604 (as shown in FIG. 12).

The following uses an example in which the thickness of the metal glass layer 342 is less than the depth of the first recess 3604 to describe step S41 in the preparation method for the semiconductor device.

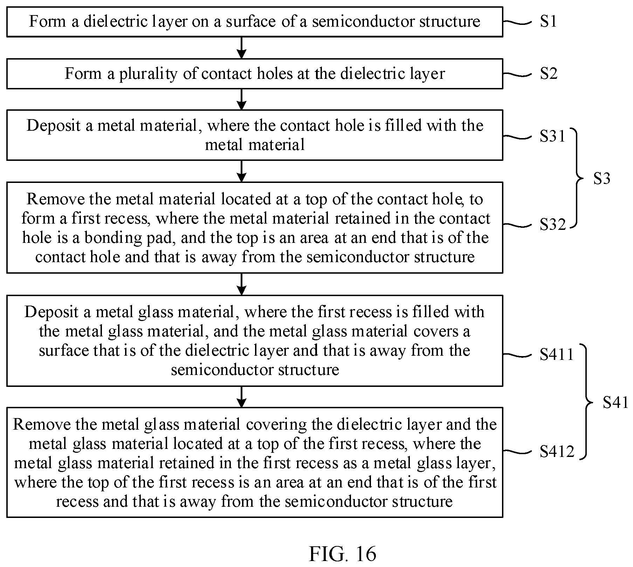

FIG. 16 is still another flowchart of a preparation method for a semiconductor device according to an embodiment of this application.

Refer to FIG. 16. In some examples, step S41 may include step S411 and step S412.

S411: Deposit a metal glass material, where the first recess is filled with the metal glass material, and the metal glass material covers a surface that is of the dielectric layer and that is away from the semiconductor structure.

Refer to FIG. 13. In step S411, the metal glass material 3420 may be formed in the first recess 3604 (as shown in FIG. 12) and the second surface 3501 of the dielectric layer 350 by using the thin film deposition process.

For example, the metal glass material 3420 may include CuZr. When the metal glass material 3420 is formed in the first recess 3604 (as shown in FIG. 12) and the second surface 3501 of the dielectric layer 350 by using the PVD process, an alloy target including CuZr may be formed in advance, and then the metal glass material 3420 is deposited on the first recess 3604 and the second surface 3501 through single-target sputtering.

Deposition time of the metal glass material 3420 is short, and deposition of the metal glass material 3420 of one semiconductor device 300 may be completed in about 10 minutes. Therefore, time costs for connecting the semiconductor devices 300 via the metal glass layers 342 are low.

In the example shown in FIG. 13, in step S411, the first recess 3604 may be filled with the metal glass material 3420, and the metal glass material 3420 may protrude from the first recess 3604. In this case, deposition thickness of the metal glass material 3420 corresponding to the first recess 3604 is greater than the depth of the first recess 3604. The metal glass material 3420 corresponding to the first recess 3604 means thickness of the metal glass material 3420 covered by the first recess 3604 in the first direction F1.

For example, a difference between the deposition thickness of the metal glass material 3420 corresponding to the first recess 3604 and the depth of the first recess 3604 may be equal to 500 Å.

In some examples, the deposition thickness of the metal glass material 3420 corresponding to the first recess 3604 is greater than or equal to 1000 Å and less than or equal to 2500 Å.

In some other examples, only a part of the first recess 3604 may be filled with the metal glass material 3420. In this case, a part of the metal glass material 3420 may be located in the bottom area of the first recess 3604, another part of the metal glass materials 3420 may cover a side wall of a top area of the first recess 3604, and another part of the metal glass materials 3420 may cover the second surface 3501 of the dielectric layer 350.

S412: Remove the metal glass material covering the dielectric layer, and the metal glass material located at the top of the first recess, where the metal glass material retained in the first recess is the metal glass layer, and the top of the first recess is an area at an end that is of the first recess and that is away from the semiconductor structure.

Refer to FIG. 14. In step S412, the metal glass material 3420 on the second surface 3501 of the dielectric layer 350 and the metal glass material 3420 on the top of the first recess 3604 are removed, and the metal glass material 3420 at the bottom of the first recess 3604 may be used as the metal glass layer 342. In this case, the first surface 3421 of the metal glass layer 342 is closer to the semiconductor structure 310 than the second surface 3501.

The metal glass layer 342 is recessed in the dielectric layer 350. In this case, the first surface 3421 of the metal glass layer 342 and the dielectric layer 350 may form expansion space. In the bonding process of the metal glass layers 342 of the bonding portions 340 of the two semiconductor devices 300, the metal glass layers 342 of the two semiconductor devices 300 may expand, and sizes of the metal glass layers 342 may increase. The first surface 3421 of the metal glass layer 342 and the dielectric layer 350 enclose the expansion space, so that the metal glass layer 342 may expand into the expansion space. This avoids a gap between the two semiconductor devices 300 after the metal glass layers 342 of the two semiconductor devices 300 are bonded due to excessive protrusion of the expanded metal glass layer 342 from the second surface 3501 of the dielectric layer 350. Therefore, the first surface 3421 is closer to the semiconductor structure 310 than the second surface 3501, to avoid a gap between the two bonded semiconductor devices 300 due to expansion of the metal glass layers 342.

For example, in step S412, the metal glass material 3420 on the second surface 3501 of the dielectric layer 350 and the metal glass material 3420 on the top of the first recess 3604 may be removed by using the polish process.

For example, the polish process may include a chemical mechanical polish (chemical mechanical polish, CMP) process.

The metal glass material 3420 on the second surface 3501 of the dielectric layer 350 may be removed by using the polish process, and then the metal glass material 3420 on the top of the first recess 3604 is removed. When the metal glass material 3420 on the top of the first recess 3604 is removed, the polish pressure and the polish time in the polish process may be adjusted, to control a distance between the first surface 3421 of the metal glass layer 342 and the second surface 3501 in the first direction F1.

In some examples, in step S412, the distance between the first surface 3421 of the metal glass layer 342 and the second surface 3501 of the dielectric layer 350 in the first direction F1 is greater than or equal to 20 Å and less than or equal to 300 Å.

For example, the distance between the first surface 3421 of the metal glass layer 342 and the second surface 3501 of the dielectric layer 350 in the first direction F1 is equal to 200 Å.

In step S412, the metal glass material 3420 on the second surface 3501 of the dielectric layer 350 and the metal glass material 3420 on the top of the first recess 3604 are removed, and the metal glass layer 342 occupies partial space of the first recess 3604.

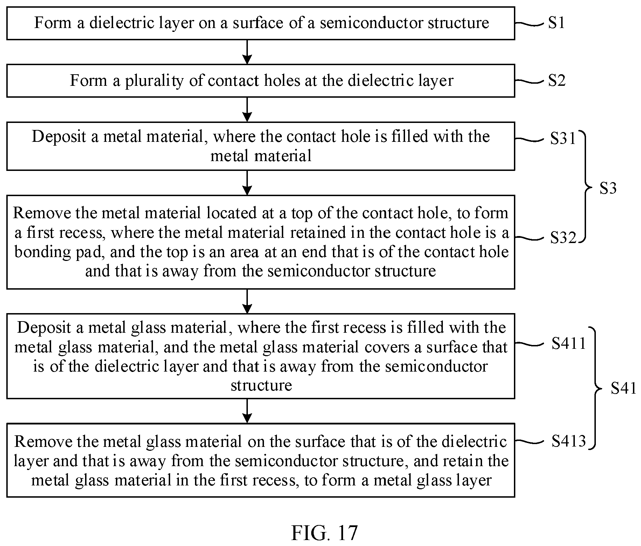

FIG. 17 is yet another flowchart of a preparation method for a semiconductor device according to an embodiment of this application.

Refer to FIG. 17. In some other examples, step S41 may include step S411 and step S413, and step S413 may be performed after step S411.

S413: Remove the metal glass material on the surface that is of the dielectric layer and that is away from the semiconductor structure, and retain the metal glass material in the first recess, to form the metal glass layer.

The metal glass layer 342 formed in step S413 may occupy all space of the first recess 3604 (as shown in FIG. 12). In this case, for a structure of the semiconductor device 300, refer to FIG. 4. For example, in step S413, the metal glass material 3420 on the second surface 3501 of the dielectric layer 350 may be removed by using the polish process. For example, the polish process may include a chemical mechanical polish (chemical mechanical polish, CMP) process.

In the embodiments provided in FIG. 7 to FIG. 14, in step S3, in a process of forming the bonding pad in the contact hole, the bonding pad 341 may be in direct contact with a hole side wall of the contact hole 360. In some other examples, before the bonding pad 341 is formed, a barrier layer and a seed layer may be formed in the contact hole 360. In this case, the bonding pad 341 may be formed through electrochemical deposition.

The following describes a preparation method for the bonding pad 341 by using an example in which the bonding pad 341 is formed by using the electrochemical deposition process.

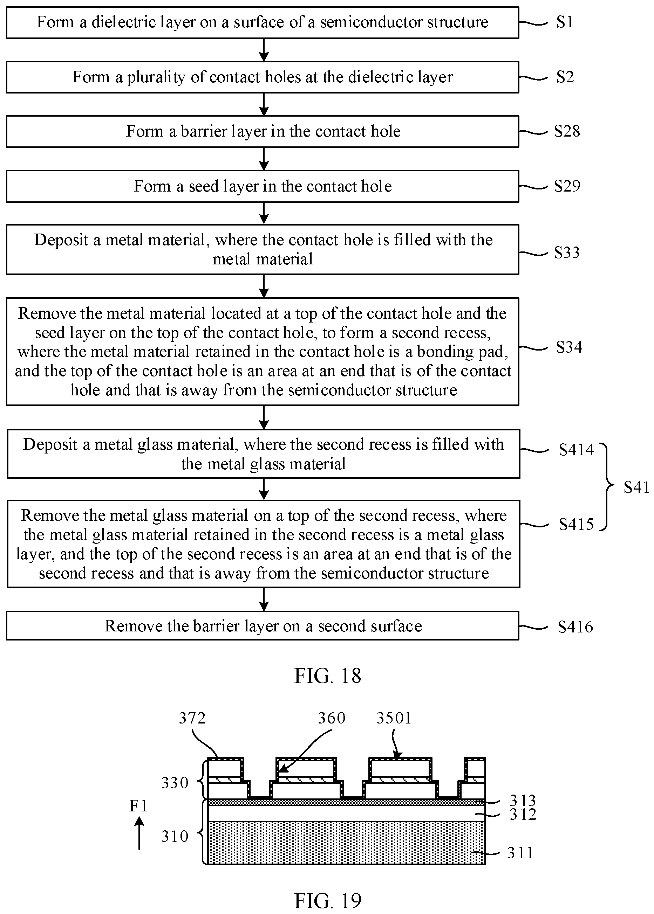

FIG. 18 is another flowchart of a preparation method for a semiconductor device according to an embodiment of this application. FIG. 19 to FIG. 24 are diagrams of steps of a preparation method for a semiconductor device according to an embodiment of this application.

Refer to FIG. 18. Step S3 may include step S28 and step S29.

S28: Form the barrier layer in the contact hole.

Refer to FIG. 19. In step S28, a barrier layer 372 may be formed by using the thin film deposition process. In step S28, the barrier layer 372 further covers the surface that is of the dielectric layer 350 and that is away from the semiconductor structure 310.

In some examples, the barrier layer 372 may include Ta (tantalum) and tantalum nitride. Because the barrier layer 372 is conductive, the barrier layer 372 may be electrically connected to the semiconductor structure 310.

S29: Form the seed layer in the contact hole.

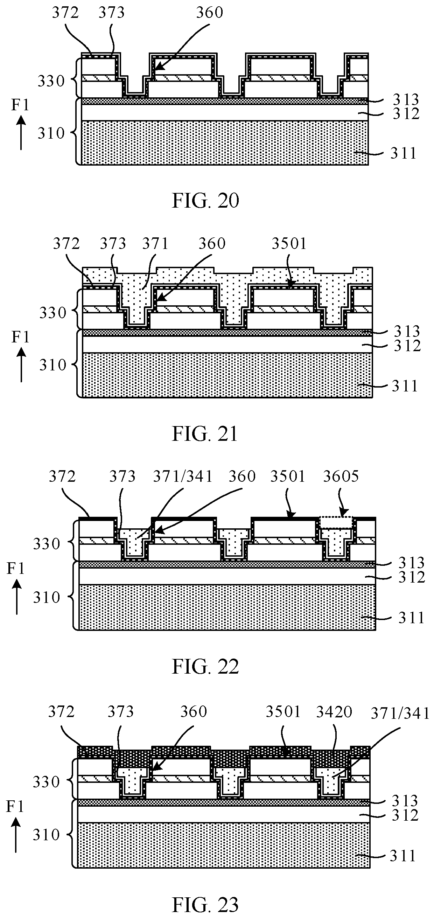

Refer to FIG. 20. In step S29, a seed layer 373 may be formed by using the physical vapor deposition method. In step S29, the seed layer 373 further covers a surface that is of the barrier layer 372 and that is away from the semiconductor structure 310.

In some examples, the seed layer 373 may include Cu, and Cu is a conductive material. Therefore, the seed layer 373 may be electrically connected to the barrier layer 372.

After step S29, step S3 may be performed to form the bonding pad in the contact hole.

It should be noted that the bonding pad 341 is formed in the contact hole 360. In this case, the bonding pad 341 and the hole wall of the contact hole 360 may be spaced apart. For example, the barrier layer 372 and the seed layer 373 are spaced between the bonding pad 341 and the hole wall of the contact hole 360. The barrier layer 372 can prevent Cu in the bonding pad 341 from diffusing into the interconnection layer 330, to ensure insulation of the interconnection layer 330. The seed layer 373 is formed in the contact hole 360, to help form the bonding pad 341.

Step S3 may include step S33 and step S34.

S33: Deposit a metal material, where the contact hole is filled with the metal material.

Refer to FIG. 21. In step S33, the contact hole 360 may be filled with the metal material, and the metal material may also cover the second surface 3501 of the dielectric layer 350. In this embodiment of this application, when the metal material 371 covers the second surface 3501, the metal material 371 may be in direct contact with the second surface 3501. In this case, a position relationship between the metal material 371 and the second surface 3501 may be shown in FIG. 11. Alternatively, the metal material 371 and the second surface 3501 may be spaced apart. In this case, the barrier layer 372 and the seed layer 373 are spaced between the metal material 371 and the second surface 3501.

A deposition process of the metal material 371 has been described in some of the foregoing embodiments. Details are not described herein again.

S34: Remove the metal material located at the top of the contact hole and the seed layer on the top of the contact hole, to form a second recess, where the metal material retained in the contact hole is the bonding pad, and the top of the contact hole is an area at an end that is of the contact hole and that is away from the semiconductor structure.

Refer to FIG. 22. In step S34, both the metal material 371 on the top of the contact hole 360 and the metal material 371 on a surface that is of the seed layer 373 and that is away from the second surface 3501 are removed. In addition, the seed layer 373 on the surface that is of the barrier layer 372 and that is away from the second surface 3501 and the seed layer 373 on the top of the contact hole 360 are further removed. The metal material 371 retained in the contact hole 360 may be used as the bonding pad 341.

In this case, the bonding pad 341, the seed layer 373 in the contact hole 360, and the barrier layer 372 in the contact hole 360 may form the second recess 3605. In FIG. 22, a dashed box indicated by a number 3605 is a position of the second recess 3605. It should be noted that the dashed box indicated by the number 3605 only indicates the position of the second recess 3605, and does not indicate an actual boundary of the second recess 3605.

After step S34, step S4 may be performed. The metal glass layer is formed in the contact hole, where the metal glass layer is stacked and in contact with the bonding pad.

In some examples, step S4 may include step S414 and step S415.

S414: Deposit a metal glass material, where the second recess is filled with the metal glass material.

Refer to FIG. 23. In step S414, the second recess 3605 may be filled with the metal glass material 3420 (as shown in FIG. 22). In this case, the second recess 3605 may be fully filled with the metal glass layer 3420, and the metal glass layer 3420 protrudes from the second recess 3605.

In addition, the metal glass material 3420 may further cover a surface that is of the barrier layer 372 and that is away from the second surface 3501 of the dielectric layer 350.

S415: Remove the metal glass material on a top of the second recess, where the metal glass material retained in the second recess is the metal glass layer, and the top of the second recess is an area at an end that is of the second recess and that is away from the semiconductor structure.

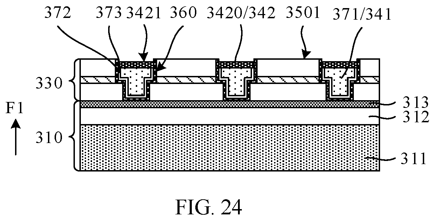

Refer to FIG. 24. The metal glass layer 342 formed in step S415 may occupy partial space of the second recess 3605 (as shown in FIG. 22). Therefore, the thickness of the metal glass layer 342 is less than a depth of the second recess 3605. In this case, the first surface 3421 of the metal glass layer 342 is closer to the semiconductor structure 310 than the second surface 3501.

The metal glass layer 342 is recessed in the dielectric layer 350. In this case, the first surface 3421 of the metal glass layer 342 and the dielectric layer 350 may form expansion space. In the bonding process of the metal glass layers 342 of the bonding portions 340 of the two semiconductor devices 300, the metal glass layers 342 of the two semiconductor devices 300 may expand, and sizes of the metal glass layers 342 may increase. The first surface 3421 of the metal glass layer 342 and the dielectric layer 350 enclose the expansion space, so that the metal glass layer 342 may expand into the expansion space. This avoids a gap between the two semiconductor devices 300 after the metal glass layers 342 of the two semiconductor devices 300 are bonded due to excessive protrusion of the expanded metal glass layer 342 from the second surface 3501 of the dielectric layer 350. Therefore, the first surface 3421 is closer to the semiconductor structure 310 than the second surface 3501, to avoid a gap between the two bonded semiconductor devices 300 due to expansion of the metal glass layers 342.

In some examples, the preparation method for the semiconductor device may further include: S416: Remove the barrier layer 372 on the second surface.

Refer to FIG. 24. After the barrier layer 372 on the second surface 3501 is removed, the second surface 3501 of the dielectric layer 350 may be exposed. The barrier layer 372 may be electrically connected to the metal glass layer 342 via the seed layer 373. Therefore, after the barrier layer 372 on the second surface 3501 is removed, a plurality of metal glass layers 342 may be prevented from being electrically connected via the barrier layer 372.

The foregoing descriptions are merely specific implementations of this application, but are not intended to limit the protection scope of this application. Any variation or replacement figured out by a person skilled in the art within the technical scope disclosed in this application shall fall within the protection scope of this application. Therefore, the protection scope of this application shall be subject to the protection scope of the claims.

## Claims

1. A semiconductor device, comprising a semiconductor structure and an interconnection layer, wherein
the interconnection layer is located on a side of the semiconductor structure, the interconnection layer comprises a plurality of bonding portions that are spaced apart, the bonding portion comprises a bonding pad and a metal glass layer, the bonding pad is connected to the semiconductor structure, and the metal glass layer covers a side that is of the bonding pad and that is away from the semiconductor structure.

2. The semiconductor device according to claim 1, wherein
the interconnection layer further comprises a dielectric layer, the bonding portion is embedded in the dielectric layer, the dielectric layer exposes a first surface of the metal glass layer, and the first surface is a surface that is of the metal glass layer and that is away from the semiconductor structure;
the dielectric layer comprises a second surface that is away from the semiconductor structure; and
the first surface is closer to the semiconductor structure than the second surface.

3. The semiconductor device according to claim 2, wherein
a distance between the first surface and the second surface in a first direction is greater than or equal to 20 Å and less than or equal to 300 Å, and the first direction is perpendicular to the first surface.

4. The semiconductor device according to claim 2 or 3, wherein
the dielectric layer comprises a first isolation layer, an intermediate layer, and a second isolation layer that are sequentially stacked on the semiconductor structure; and
the bonding pad is embedded in the first isolation layer, the intermediate layer, and the second isolation layer, and the metal glass layer is embedded in the second isolation layer.

5. The semiconductor device according to any one of claims 1 to 4, wherein
a ratio of thickness of the bonding pad to thickness of the metal glass layer is greater than or equal to 10.55 and less than or equal to 158.9.

6. The semiconductor device according to any one of claims 1 to 5, wherein
the bonding pad comprises a first part and a second part, one end of the first part is connected to the semiconductor structure, the second part is connected to the other end of the first part, a cross-sectional area of the first part on a first reference plane is less than a cross-sectional area of the second part on a second reference plane, and the first reference plane and the second reference plane are both parallel to the surface that is of the metal glass layer and that is away from the semiconductor structure;
a ratio of thickness of the first part to the thickness of the metal glass layer is greater than or equal to 5.55 and less than or equal to 75; and
a ratio of thickness of the second part to the thickness of the metal glass layer is greater than or equal to 5 and less than or equal to 83.9.

7. The semiconductor device according to any one of claims 1 to 6, wherein
the thickness of the metal glass layer is greater than or equal to 200 Å and less than or equal to 900 Å.

8. The semiconductor device according to any one of claims 1 to 7, wherein
the thickness of the bonding pad is greater than or equal to 9500 Å and less than or equal to 31780 Å.

9. The semiconductor device according to any one of claims 1 to 8, wherein
a material of the metal glass layer comprises CuZr.

10. A chip, comprising:
two semiconductor devices according to any one of claims 1 to 9, wherein metal glass layers of a plurality of bonding portions of the two semiconductor devices are bonded, to form a plurality of bonding connection portions.

11. The chip according to claim 10, wherein
in the semiconductor device, there is a recess on a surface that is of a bonding pad of the bonding portion and that is away from a semiconductor structure of the semiconductor device, and the recess is filled with a part of the bonding connection portion.

12. The chip according to claim 10 or 11, wherein
a material of the bonding connection portion comprises CuZr and single-crystal Cu.

13. An electronic device, comprising:
a circuit board; and
the chip according to any one of claims 10 to 12, wherein the chip is disposed on the circuit board.

14. A preparation method for a semiconductor device, comprising:
forming a dielectric layer on a surface of a semiconductor structure;
forming a plurality of contact holes at the dielectric layer;
forming a bonding pad in the contact hole; and
forming a metal glass layer in the contact hole, wherein the metal glass layer is stacked and in contact with the bonding pad.

15. The preparation method for the semiconductor device according to claim 14, wherein
the forming the bonding pads in the plurality of contact holes comprises:
depositing a metal material, wherein the contact hole is filled with the metal material; and
removing the metal material located at a top of the contact hole, to form a first recess, wherein the metal material retained in the contact hole is the bonding pad, and the top of the contact hole is an area at one end that is of the contact hole and that is away from the semiconductor structure; and
the forming the metal glass layer in the contact hole comprises:
forming the metal glass layer in the first recess.

16. The preparation method for the semiconductor device according to claim 15, wherein
the forming the metal glass layer in the first recess comprises:
depositing a metal glass material, wherein the first recess is filled with the metal glass material, and the metal glass material covers a surface that is of the dielectric layer and that is away from the semiconductor structure; and
removing the metal glass material on the surface that is of the dielectric layer and that is away from the semiconductor structure, and retaining the metal glass material in the first recess, to form the metal glass layer.

17. The preparation method for the semiconductor device according to claim 15, wherein
the forming the metal glass layer in the first recess comprises:
depositing a metal glass material, wherein the first recess is filled with the metal glass material, and the metal glass material covers a surface that is of the dielectric layer and that is away from the semiconductor structure; and
removing the metal glass material on the surface that is of the dielectric layer and that is away from the semiconductor structure and the metal glass material located at a top of the first recess, wherein the metal glass material retained in the first recess is the metal glass layer, wherein the top of the first recess is an area at an end that is of the first recess and that is away from the semiconductor structure.
